# EUROPEAN PATENT APPLICATION

(11) **EP 2 373 135 A1**
(43) Date of publication of application: **05.10.2011**
(21) Application number: 11158025.4
(22) Date of filing: 14.03.2011
(51) Int. Cl.: H05K 3/22, H05K 3/30, H05K 3/34

(54) **Printed Circuit Board and Method of Fabricating Printed Circuit Board**

(30) Priority: 30.03.2010 JP 2010079159
(71) Applicant: FUJITSU LIMITED, Kawasaki-shi, Kanagawa 211-8588 (JP)
(72) Inventor: Nakamura, Naoki, Kawasaki-shi, Kanagawa 211-8588 (JP); Taketomi, Nobuo, Kawasaki-shi Kanagawa 211-8588 (JP); Hatanaka, Kiyoyuki, Kawasaki-shi Kanagawa 211-8588 (JP); Iriguchi, Shigeo, Kawasaki-shi Kanagawa 211-8588 (JP)
(74) Representative: Wilding, Frances Ward

(57) **Abstract**

A printed circuit board includes a printed circuit board body and a resin layer. The printed circuit board body includes a plurality of mounting pads. The resin layer, containing a thermoplastic resin, is formed on the surface of the printed circuit board body. The resin layer includes a plurality of holes disposed to be aligned with the positions of the mounting pads on a one-to-one basis for exposing the mounting pads therethrough. In a method of fabricating the printed circuit board, the resin layer is formed atop the printed circuit board body.

## Description

### FIELD

The present invention relates to a printed circuit board that electronic components have not been mounted and a method of fabricating the printed circuit board.

### BACKGROUND

In the recent portable electronic devices (the mobile phones, the laptop personal computers and etc.), a reinforcement resin called "underfill" is applied to clearances between electronic components and a printed circuit board for reinforcing joints between the electronic components and the printed circuit board. Reinforcement is herein executed for preventing the joint portions of the electronic components from being destroyed by large impact, for instance, applied when the portable electronic devices fall down. A thermosetting adhesive material (e.g., an epoxy resin with a high adhesive strength) is used as the above reinforcement resin.

On the other hand, a resin formed by blending a thermosetting adhesive material and a thermoplastic adhesive material may be used as the reinforcement resin to be used as the underfill for repairing the electronic components when there is something wrong with either the electronic components themselves or the joints of the electronic components to the printed circuit board,.

Japan Laid-open Patent Application Publication No. JP-A-2001-007488 discusses one of the currently well-known semiconductor device mounting structures for mounting a semiconductor device having protruded electrodes on a circuit board having contact pads corresponding to the protruded electrodes. In the semiconductor device mounting structure, a first resin having a thermoplastic property is disposed on an inner region surrounded by the contact pads. Further, a second resin, which contains a filler and has a thermosetting property, is disposed in an outer region arranged outside of the inner region while being interposed between the semiconductor device and the circuit board.

According to the aforementioned semiconductor device mounting structure, the first resin having a thermoplastic property is disposed in the inner region surrounded by the contact pads whereas the second resin, which contains a filler and has a thermosetting property, is interposed between the semiconductor device and the circuit board. Therefore, the aforementioned publication discusses the following working effects. Simply put, the semiconductor device is allowed to be easily repaired. Further, highly reliable connection is achieved due to the adhesive strength of the second resin. Yet further, thermal stress is relieved in the contact portion.

However, a problem is produced when the aforementioned semiconductor device mounting structure is applied to a semiconductor package provided with a plurality of solder bumps disposed at predetermined intervals, such as a BGA (Ball Grid Array). Simply put, a solder paste and the first resin may be mixed with each other. Mixture of solder bumps and the resin is not preferable in that an unnecessary resin is mixed with electric contact portions made of a solder, which causes a negative impact on the quality of the semiconductor package.

Further, it is not preferable in that the number of operational steps is increased in a mounting operation for mounting a semiconductor device having the aforementioned mounting structure on a circuit board due to an additional step of applying the first resin to the mounting surface of the semiconductor device.

### SUMMARY

The aspects of the present invention are described in the attached independent claims, to which reference should now be made, with various preferred embodiments given in the dependent claims.

In view of the above, it is desirable to provide a printed circuit board and a method of fabricating a printed circuit board for inhibiting increase in the number of operational steps and efficiently fabricating a printed circuit board unit which is repairable and has a sufficient reinforcement strength for the joint with the electronic component when the electronic component provided with a plurality of solder joints is mounted on the printed circuit board.

According to an embodiment of an aspect of the present invention, a printed circuit board includes: a printed circuit board body including a plurality of mounting pads; and a resin layer including a thermoplastic resin to be formed on a surface of the printed circuit board body. Further, the resin layer includes a plurality of holes disposed to be aligned with positions of the mounting pads on a one-to-one basis for exposing the respective mounting pads therethrough.

According to an embodiment of another aspect of the present invention, a printed circuit board includes: a printed circuit board body including a plurality of mounting pads; and a resin layer of a B-staged state to be formed on a surface of the printed circuit board body. Further, the resin layer includes a plurality of holes disposed to be aligned with the mounting pads on a one-to-one basis for exposing the respective mounting pads therethrough.

According to an embodiment of yet another aspect of the present invention, a method of fabricating a printed circuit board includes: fabricating a printed circuit board body including a plurality of mounting pads; and forming on a surface of the printed circuit board body either a resin layer containing a thermoplastic resin or a resin layer of a B-staged state that includes a plurality of holes disposed to be aligned with positions of the mounting pads on a one-to-one basis for exposing the respective mounting pads therethrough.

### BRIEF DESCRIPTION OF DRAWINGS

Referring now to the attached drawings which form a part of this original disclosure:
FIG. 1 is a diagram illustrating an exemplary portable electronic device having a printed circuit board unit of exemplary embodiments of the present invention embedded therein;
FIG. 2 is a plan view of an exemplary printed circuit board of a first exemplary embodiment;
FIG. 3 is a cross-sectional view of the printed circuit board illustrated in FIG. 2;
FIG. 4 is a diagram illustrating a semiconductor package mounted on the printed circuit board illustrated in FIG. 2;
FIG. 5 is a plan view of an exemplary printed circuit board of a second exemplary embodiment;
FIG. 6 is a diagram illustrating a semiconductor package mounted on the printed circuit board illustrated in FIG. 5;
FIG. 7 is an enlarged fragmental plan view of an exemplary printed circuit board of a third exemplary embodiment;
FIG. 8 is an enlarged fragmental plan view of an exemplary printed circuit board of a fourth exemplary embodiment;
FIG. 9A is an enlarged fragmental plan view of another exemplary printed circuit board of the fourth exemplary embodiment;
FIG. 9B is a cross-sectional view of the printed circuit board along a line X-X' illustrated in FIG. 9A.
FIG. 10A is an enlarged fragmental plan view of yet another exemplary printed circuit board of the fourth exemplary embodiment;
FIG. 10B is a cross-sectional view of the printed circuit board illustrated in FIG. 10A, which is sectioned along a line X-X';
FIG. 11A is a flowchart representing an exemplary flow in a method of fabricating a printed circuit board of the present exemplary embodiments;
FIG. 11B is a flowchart representing another exemplary flow in the method of fabricating a printed circuit board of the present exemplary embodiments; and
FIG. 11C is a flowchart representing yet another exemplary flow in the method of fabricating a printed circuit board of the present exemplary embodiments;

### DESCRIPTION OF EMBODIMENT(S)

A printed circuit board and a method of fabricating a printed circuit board of the present invention will be hereinafter explained.

### (Printed Circuit Board Unit)

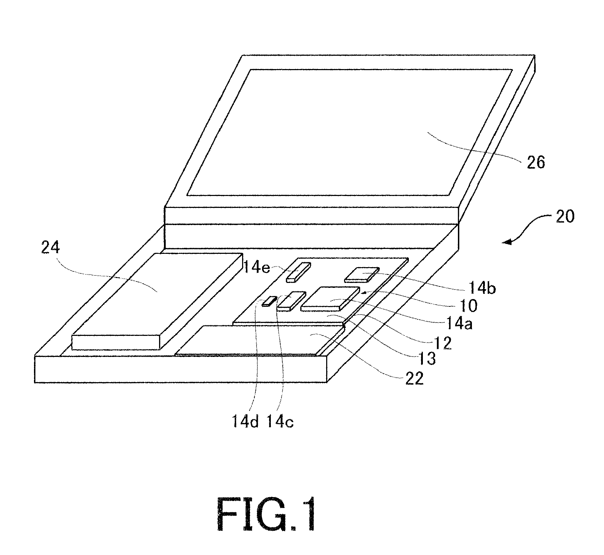

FIG. 1 is a schematic diagram of all internal, configuration of a portable electronic device 20 including a printed circuit board unit 10 that electronic components are mounted on a printed circuit board. Input operation units such as a keyboard and a mouse/touchpad are detached from the portable electronic device 20 illustrated in FIG. 1. The portable electronic device 20 includes units 22 and 24 (a battery unit, a wireless transceiver unit, and etc.) and a display 26 in addition to the printed circuit board unit 10 including a CPU and the like.

### (First Exemplary Embodiment Printed Circuit Board)

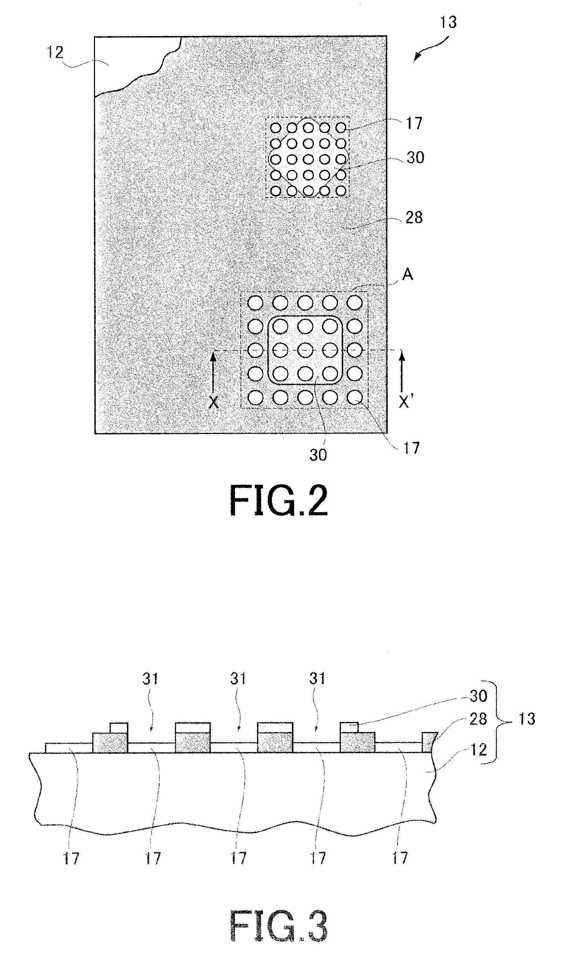

FIG. 2 is a plan view of a printed circuit board 13 according to a first exemplary embodiment of the present invention. FIG. 3 is a cross-sectional view of the printed circuit board 13 along a line X-X' illustrated in FIG. 2.

The printed circuit board 13 includes a printed circuit board body 12, a solder resist layer 28 disposed on the printed circuit board body 12 and a first reinforcement resin layer 30.

The printed circuit board unit 10 is fabricated by mounting a plurality of electronic components (i.e., semiconductor packages 14a, 14b, 14c, 14d and 14e) on a surface of a printed circuit board 13. The semiconductor packages 14a and 14b, amongst the semiconductor packages 14a, 14b, 14c, 14d and 14e, respectively include a plurality of ball shaped solder joint portions (solder bumps) arranged at predetermined intervals on the surface thereof faced to the printed circuit board 13. Each solder contact portion is soldered and electrically connected to a corresponding one of mounting pads 17 of the printed circuit board 13 as a connection terminal of the semiconductor package 14a (14b). For example, the semiconductor packages 14a and 14b employ BGA (Ball Grid Array). The semiconductor packages 14a and 14b may employ LGA (Land Grid Array), CSP (Chip Size Package) or the like. Therefore, the solder contact portions of the semiconductor package 14a (14b) are positioned between the body of the semiconductor package 14a (14b) and the printed circuit board 13. Connection terminals of the semiconductor packages 14c to 14e (not illustrated in the figures) are also connected to the corresponding mounting pads disposed on the printed circuit board 13.

The printed circuit board 13 will be hereinafter explained. Components to be mounted on the printed circuit board 13 are not herein limited to the semiconductor packages. For example, the components may be electronic components such as the passive devices and the active devices.

As explained below, the first reinforcement resin layer 30 is preliminarily formed in prospective mounting regions for the semiconductor packages 14a and 14b on the aforementioned printed circuit board 13. The first reinforcement resin layer 30 is disposed for reinforcing soldering of the semiconductor packages 14a and 14b to an extent that soldering of the semiconductor packages 14a and 14b can be sufficiently maintained even if large stress or impact is applied to the semiconductor 14a and 14b when the portable electronic device 20 falls down to the floor or receives external pressure.

As illustrated in FIG. 3, the printed circuit board 13 has a structure that the solder resist layer 28 is disposed atop the printed circuit board body 12 and the first reinforcement resin layer 30 is disposed atop a partial region of the solder resist layer 28.

The printed circuit board body 12 may be a build-up substrate, a flexible substrate or the like. The build-up substrate herein has a structure that a plurality of wiring layers is laminated on a core substrate (either a dielectric substrate or a single- or multi-layer laminated substrate using a glass fiber or a resin) while an insulator sheet (an epoxy resin sheet, a polyimide resin sheet, or the like) is interposed between every adjacent wiring layers. The printed circuit board body 12 includes a plurality of the mounting pads 17 in prospective mounting regions for the semiconductor packages 14a and 14b on the mounting surface thereof.

The solder resist layer 28 is a thermosetting resin layer disposed for preventing a solder from being attached to regions exempted from soldering on the printed circuit board body 12. The solder resist layer 28 includes a plurality of holes for exposing the mounting pads 17 to be soldered therethrough on a one-to-one basis. For example, a thermosetting epoxy resin is used as the solder resist layer 28. The first reinforcement resin layer 30 is laminated atop a partial region of the solder resist layer 28.

The first reinforcement resin layer 30 is a resin layer containing a thermoplastic resin. The first reinforcement resin layer 30 is herein in a dry state or at least in a half-cured state. As illustrated in FIG. 3, the first reinforcement resin layer 30 further includes a plurality of through holes 31 for exposing the mounting pads 17 therethrough on a one-to-one basis. In other words, the through holes 31 are respectively disposed to be aligned with the positions of the mounting pads 17.

The through holes 31 are herein disposed to be aligned with the mounting pads 17 for preventing a negative impact on conductivity or performance of the semiconductor package 14a (14b) due to the resin incorporated as an impure substance into the joint portions between the solder bumps 16 and the mounting pads 17 when the semiconductor package 14a (14b) is mounted on the printed circuit board 13.

The first reinforcement resin layer 30 is disposed in a part of the prospective mounting region for the semiconductor package 14a (14b). As illustrated in FIG. 2, the first reinforcement resin layer 30 is specifically disposed in the inner portions of the prospective mounting regions for the semiconductor packages 14a and 14b (i.e., regions respectively enclosed by dotted lines in FIG. 2) and away from the edge portions of the prospective mounting regions.

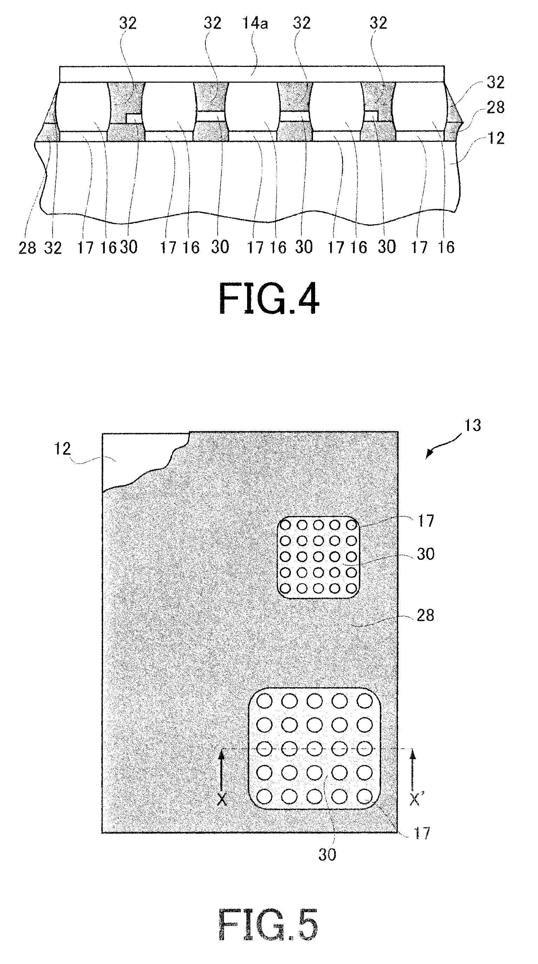

The first reinforcement resin layer 30 preferably has any suitable thickness for producing a height of 150 µm or less from the mounting pad 17 to the top surface of the first reinforcement resin layer 30. The height from the mounting pads 17 to the semiconductor packages 14a and 14b to be mounted on the printed circuit board 13 by means of soldering (hereinafter referred to as "mounting height") is preliminarily determined. The height from the mounting pads 17 to the top surface of the first reinforcement resin layer 30 is preferably set to be lower than the mounting height. The mounting height is roughly 150 µm. The height of 150 µm or less from the mounting pads 17 to the top surface of the first reinforcement resin layer 30 allows to make a clearance between the first reinforcement resin layer 30 and the mounting surfaces of the semiconductor packages 14a and 14b to be mounted on the printed circuit board 13. Joint can be further reinforced between the semiconductor package 14a (14b) and the printed circuit board 13 by filling the clearance with a second reinforcement resin layer 32 to be described (see FIG. 4). The second reinforcement resin layer 32 contains a thermosetting resin with a high adhesive strength.

FIG. 4 is a cross-sectional view illustrating the semiconductor package 14a mounted on the printed circuit board 13 illustrated in FIG. 3. The semiconductor package 14b is also mounted on the printed circuit board 13 in the same way as illustrated in FIG. 4.

As described above, the first reinforcement resin layer 30 is thermoplastic resin. When the first reinforcement resin layer 30 is heated, its adhesive strength is reduced and its adhesive property is deteriorated. The semiconductor package 14a can be easily removed from the printed circuit board 13 by breaking the second reinforcement resin layer 32 containing a thermosetting resin and simultaneously peeling the semiconductor package 14a from the printed circuit board 13.

On the other hand, the entire surface of the semiconductor package 14a, excluding the solder bumps 16, makes contact with the second reinforcement resin layer 32 having a high adhesive strength, as illustrated in FIG. 4. Joint is thereby reinforced between the semiconductor package 14a and the printed circuit board 13 through the second reinforcement resin layer 32. Consequently, joint can be sufficiently reinforced between the semiconductor package 14a and the printed circuit board 13, while the printed circuit board 13 allows the semiconductor package 14a to be repaired.

Therefore, the height from the mounting pad 17 to the top surface of the first reinforcement resin layer 30 is preferably 150 µm or less for actually laminating the first reinforcement resin layer 30 and the second reinforcement resin layer 32. The configuration allows a clearance to be made between the first reinforcement resin layer 30 and the mounting surface of the semiconductor package 14a to be mounted on the printed circuit board 13.

Further, preparation of the printed circuit board 13 illustrated in FIG. 3 reduces the number of operational steps for mounting the semiconductor package 14a on the printed circuit board 13 and achieves efficient mounting of the semiconductor package 14a on the printed circuit board 13.

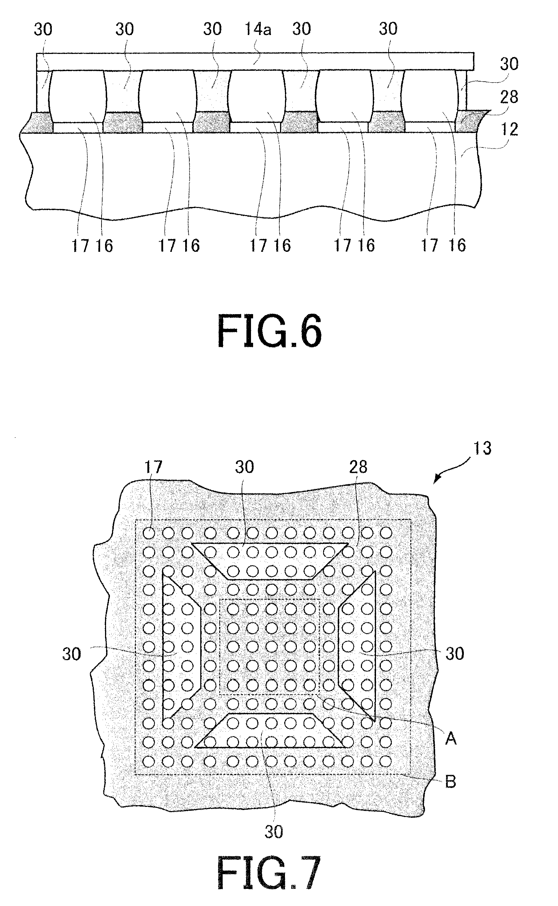

(Second Exemplary Embodiment Printed Circuit Board) FIGS. 5 and 6 are diagrams illustrating the printed circuit board 13 of a second exemplary embodiment. FIG. 5 is a plan view of the printed circuit board 13 of the second exemplary embodiment. FIG. 6 is a cross-sectional view of the printed circuit board 13 along a line X-X' illustrated in FIG. 5, on which the semiconductor package 14a is mounted.

Similarly to the printed circuit board 13 of the first exemplary embodiment, the printed circuit board 13 of the second exemplary embodiment has a structure that the solder resist layer 28 is disposed atop the printed circuit board body 12 and the first reinforcement resin layer 30 is disposed atop a partial region of the solder resist layer 28.

The second exemplary embodiment is different from the first exemplary embodiment regarding regions for disposing the first reinforcement resin layer 30. As illustrated in FIG. 5, the first reinforcement resin layer 30 is disposed on the entire surface of the prospective mounting regions for the semiconductor packages 14a and 14b. The first reinforcement resin layer 30 includes a plurality of through holes formed to be aligned with the positions of the respective mounting pads 17. The respective mounting pads 17 are exposed through the through holes on a one-to-one basis. Further, the thickness of the first reinforcement resin layer 30 is herein greater than that of the first reinforcement resin layer 30 of the first exemplary embodiment. As illustrated in FIG. 6, the top surface of the first reinforcement resin layer 30 makes contact with the mounting surface of the semiconductor package layer 14a when the semiconductor package 14a is mounted on the printed circuit board 13. Therefore, the second reinforcement resin layer 32, used in first exemplary embodiment, is not used in the second exemplary embodiment.

As described above, joint can be reinforced between the semiconductor package 14a and the printed circuit board 13 using the first reinforcement resin layer 30 without using the second reinforcement resin layer 32 having a high adhesive strength. In this case, however, it is preferable to use, as the resin of the first reinforcement resin layer 30, such a type of resin that has a thermoplastic property and contains a thermosetting resin. Further, for the semiconductor packages 14a to be mounted on the printed circuit board 13 of the second exemplary embodiment, such types of semiconductor packages that have low mass and are mounted on regions less subjected to stress or impact are preferably applied.

The printed circuit board 13 of the second exemplary embodiment also allows the semiconductor package 14a to be repaired. Further, joint can be reinforced between the semiconductor package 14a and the printed circuit board 13.

Further, preparation of the printed circuit board 13 of the second exemplary embodiment reduces the number of operational steps for mounting the semiconductor package 14a on the printed circuit board 13 and achieves efficient mounting of the semiconductor package 14a on the printed circuit board 13.

### (Third Exemplary Embodiment Printed Circuit Board)

FIG. 7 is a plan view illustrating a prospective mounting area for the semiconductor package 14a and the periphery thereof on the printed circuit board 13 of the third exemplary embodiment.

Similarly to the printed circuit board 13 of the first exemplary embodiment, the printed circuit board 13 of the third exemplary embodiment has a structure that the solder resist layer 28 is disposed atop the printed circuit board body 12 and the first reinforcement resin layer 30, containing a thermoplastic resin, is disposed atop a partial region of the solder resist layer 28. A plurality of the mounting pads 17 of the printed circuit board 13 are exposed through a plurality of holes formed in the solder resist layer 28. In the regions where the first reinforcement resin layer 30 is disposed, respective mounting pads 17 are exposed through the holes formed in the solder resist layer 28 and a plurality of the through holes formed in the first reinforcement resin layer 30 on a one-to-one basis.

The third exemplary embodiment is herein different from the first exemplary embodiment regarding the regions where the first reinforcement resin layer 30 is disposed.

The semiconductor package 14a having a semiconductor chip configured to be mounted on the printed circuit board 13 illustrated in FIG. 7. A dotted line A in FIG. 7 indicates a region of the printed circuit board 13 where the semiconductor chip is positioned in mounting the semiconductor package 14a on the printed circuit board 13 (hereinafter referred to as "a prospective region for the semiconductor chip"). Further, a dotted line B in FIG. 7 indicates a prospective mounting region for the semiconductor package 14a on the printed circuit board 13.

The first reinforcement resin layer 30 includes four trapezoid portions. The trapezoid portions are disposed on the outside of the prospective region for the semiconductor chip away from an edge portion of the prospective region. In other words, the first reinforcement resin layer 30 is disposed in a region sandwiched between the edge portion of the prospective region for the semiconductor chip (i.e., the region enclosed by the dotted line A) and an edge portion of the prospective mounting region for the semiconductor package 14a (i.e., the region enclosed by the dotted line B). Further, the four portions of the first reinforcement resin layer 30 are in four regions partitioned by two diagonals of the rectangular prospective mounting region for the semiconductor package 14a and away from the diagonals.

The first reinforcement resin layer 30 is preferably set to have any suitable thickness for producing a height of 150 µm or less from the mounting pad 17 to the top surface of the first reinforcement resin layer 30. A clearance can be made between the first reinforcement resin layer 30 and the mounting surface of the semiconductor package 14a to be mounted on the printed circuit board 13 by setting the thickness of the first reinforcement resin layer 30 such that the height from the mounting pad 17 to the top surface of the first reinforcement resin layer 30 may be 150 µm or less. As explained in the first exemplary embodiment, it is herein possible to form a multilayer adhesive layer that the second reinforcement resin layer 32 is disposed atop the first reinforcement resin layer 30 when the second reinforcement resin layer 32, having an adhesive strength greater than that of the first reinforcement resin layer 30, is provided in the clearance. Consequently, the mounting surface of the semiconductor package 14a is allowed to make contact with the second reinforcement resin layer 32 in both of the regions where the first reinforcement resin layer 30 is disposed and the remaining region where the first reinforcement resin layer 30 is not disposed.

As described above, the first reinforcement resin layer 30 contains a thermoplastic resin. When the first reinforcement resin layer 30 is heated, its adhesive strength is reduced and its adhesive property is deteriorated. The first reinforcement resin layer 30 is thereby allowed to be easily removed from the printed circuit board body 12 and is allowed to be repaired. On the other hand, the entire mounting surface of the semiconductor package 14a, excluding the portions over the solder bumps 16, makes contact with the second reinforcement resin layer 32 having a high adhesive strength. Therefore, joint is sufficiently reinforced between the semiconductor package 14a and the printed circuit board 13 through the second reinforcement resin layer 32.

The first reinforcement resin layer 30 is herein disposed on the outside of the prospective region for the semiconductor chip away from the edge portion of the prospective region for the semiconductor chip due to the fact that the semiconductor package 14a is subjected to relatively small stress and impact on the outside of the prospective region. Therefore, reinforcement is not reduced in the joint between the semiconductor package 14a and the printed circuit board 13 even when the first reinforcement resin layer 30 is disposed on the outside of the prospective region. It is herein noted that the edge portion of the prospective region for the semiconductor chip is easily subjected to thermal stress.

Further, the first reinforcement resin layer 30 is disposed away from the diagonals of the rectangular prospective mounting region for the semiconductor package 14a due to the fact that the semiconductor package 14a is subjected to relatively small stress and impact on the outside of the aforementioned prospective region for the semiconductor chip excluding the diagonals of the rectangular prospective mounting region for the semiconductor package 14a. Therefore, reinforcement is not reduced in the joint between the semiconductor package 14a and the printed circuit board 13 even when the first reinforcement resin layer 30 is disposed on the outside of the aforementioned prospective region for the semiconductor chip and away from the diagonals of the rectangular prospective mounting region for the semiconductor package 14a.

### (Fourth Exemplary Embodiment Printed Circuit Board)

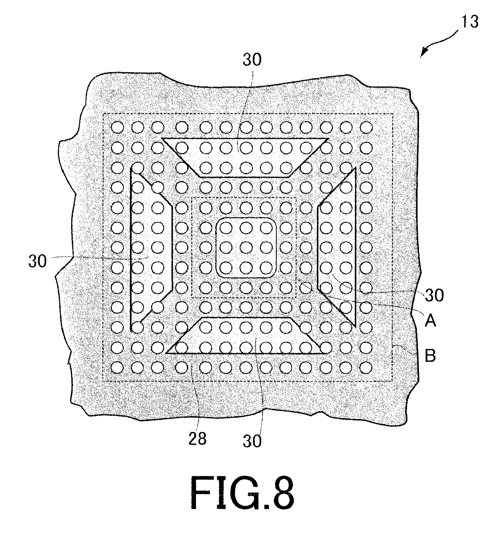

FIG. 8 is a plan view illustrating a prospective mounting region for the semiconductor package 14a and the periphery thereof on the printed circuit board 13 of the fourth exemplary embodiment.

Similarly to the printed circuit board 13 of the first exemplary embodiment, the printed circuit board 13 of the fourth exemplary embodiment has a structure that the solder resist layer 28 is disposed atop the printed circuit board body 12 and the first reinforcement resin layer 30, containing a thermoplastic resin, is disposed atop a partial region of the solder resist layer 28. The mounting pads 17 of the printed circuit board 13 are exposed through a plurality of the holes formed in the solder resist layer 28 to be aligned with the mounting pads 17 on a one-to-one basis. In the regions where the first reinforcement resin layer 30 is disposed, the mounting pads 17 are exposed through the holes formed in the solder resist layer 28 to be aligned with the mounting pads 17 on a one-to-one basis and simultaneously through a plurality of the holes formed in the first reinforcement resin layer 30 to be aligned with the mounting pads 17 on a one-to-one basis.

The fourth exemplary embodiment is herein different from the third exemplary embodiment regarding a part of the regions where the first reinforcement resin layer 30 is disposed. However, there is no difference between the third and fourth exemplary embodiments regarding the rest of the regions where the first reinforcement resin layer 30 is disposed. Therefore, only the difference will be hereinafter explained.

Similarly to the semiconductor package 14a of the third exemplary embodiment, the semiconductor package 14a having a semiconductor chip embedded therein is configured to be mounted on the printed circuit board 13 illustrated in FIG. 8.

The first reinforcement resin layer 30 illustrated in FIG. 8 includes four trapezoid portions and a rectangular portion. The trapezoid portions are disposed on the outside of a prospective region for the semiconductor chip and away from an edge portion of the prospective region. The rectangular portion is disposed on an inner portion of the prospective region for the semiconductor chip and away from the edge portion of the prospective region for the semiconductor chip.

The first reinforcement resin layer 30 is herein disposed on the inner portion of the prospective region for the semiconductor chip and away from the edge portion of the prospective region for the semiconductor chip due to the fact that the semiconductor package 14a is subjected to relatively small stress and impact on the inner portion of the prospective region for the semiconductor chip. Therefore, reinforcement is not reduced in the joint between the semiconductor package 14a and the printed circuit board 13 even when the first reinforcement resin layer 30 is disposed in the inner portion of the aforementioned prospective region for the semiconductor chip.

It is herein noted that the solder resist layer 28, disposed on the printed circuit board 13, may be either an over-resist type or an open-resist type.

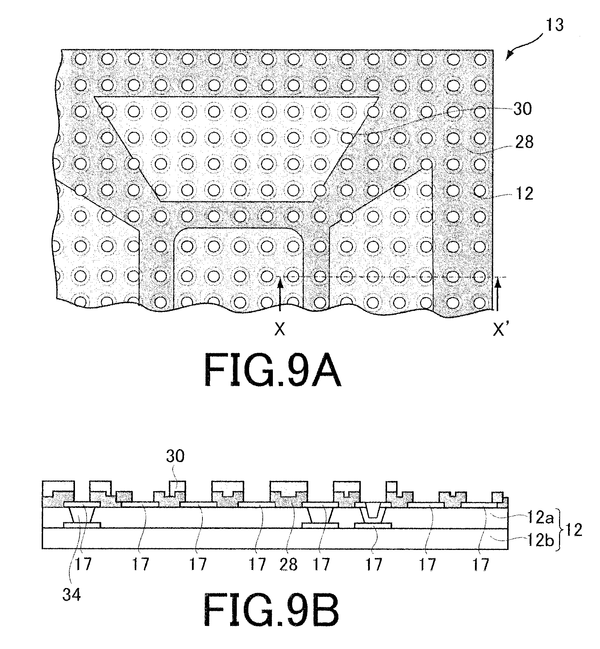

FIGS. 9A and 9B illustrate an exemplary over-resist type solder resist layer 28 disposed on the printed circuit board 13 of the fourth exemplary embodiment. FIG. 9A is a detailed and enlarged fragmental plan view of the prospective mounting region for the semiconductor package 14a on the solder resist layer 28. FIG. 9B is a cross-sectional view of the printed circuit board 13 along a line X-X' illustrated in FIG. 9A.

As illustrated in FIGS. 9A and 9B, all the portions of the first reinforcement resin layer 30 are disposed atop the solder resist layer 28. Therefore, at least the edge portion of each mounting pad 17 is covered with the solder resist layer 28 in the region where the first reinforcement resin layer 30 is disposed.

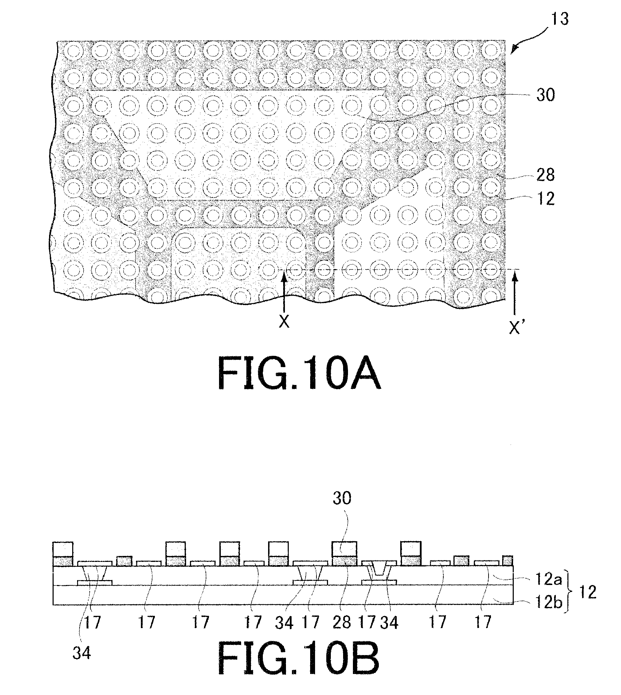

As illustrated in FIG. 9B, it is noted that the printed circuit board 13 has a structure that a plurality of wiring layers 12a and 12b is laminated and the wiring of the lower wiring layer 12b is connected to the mounting pads 17 through via-holes FIGS. 10A and 10B illustrate an exemplary open-resist type solder resist layer 28 on the printed circuit board 13 of the fourth exemplary embodiment. FIG. 10A is a detailed and enlarged fragmental plan view of a prospective mounting region for the semiconductor package 14a on the solder resist layer 28. FIG. 10B is a cross-sectional view of the printed circuit board 13 along a line X-X' illustrated in FIG. 10A.

As illustrated in FIGS. 10A and 10B, the first reinforcement resin layer 30 is disposed atop the solder resist layer 28. Therefore, the top surface of the printed circuit board body 12 is exposed in the periphery of the mounting pads 17 disposed in the region where the first reinforcement resin layer 30 is disposed.

It is herein noted that the printed circuit board 13 has a structure that a plurality of wiring layers 12a and 12b is laminated and the wiring of the lower wiring layer 12b is connected to the mounting pads 17 through via-holes 34 as illustrated in FIG. 10B.

In all the aforementioned first to fourth exemplary embodiments, the first reinforcement resin layer 30 containing a thermoplastic resin is a layer in a dry state or at least a half-cured state. When the first reinforcement resin layer 30 is a layer in a half-cured state (i.e., a B-staged state), however, the first reinforcement resin layer 30 may include either a thermoplastic resin or a thermosetting resin. Alternatively, the first reinforcement resin later 30 may have a thermosetting property. Prior to mounting of the semiconductor packages 14a and 14b on the printed circuit board 13, the first reinforcement resin layer 30 may be in any suitable state as long as it is in a non-liquid state for preventing mixture with a solder paste to be printed.

When a thermoplastic resin is once cured and then plasticized again, its adhesive strength is reduced. Therefore, the adhesive strength of the first reinforcement resin layer 30 can be enhanced by keeping the first reinforcement resin layer 30 in a half-cured state on the printed circuit board 13 before mounting of the semiconductor packages 14a and 14b for allowing the first reinforcement resin layer 30 to be heated for the first time in soldering.

### (Method of Fabricating Printed Circuit Board)

Next, a method of fabricating the printed circuit board 13 will be hereinafter explained.

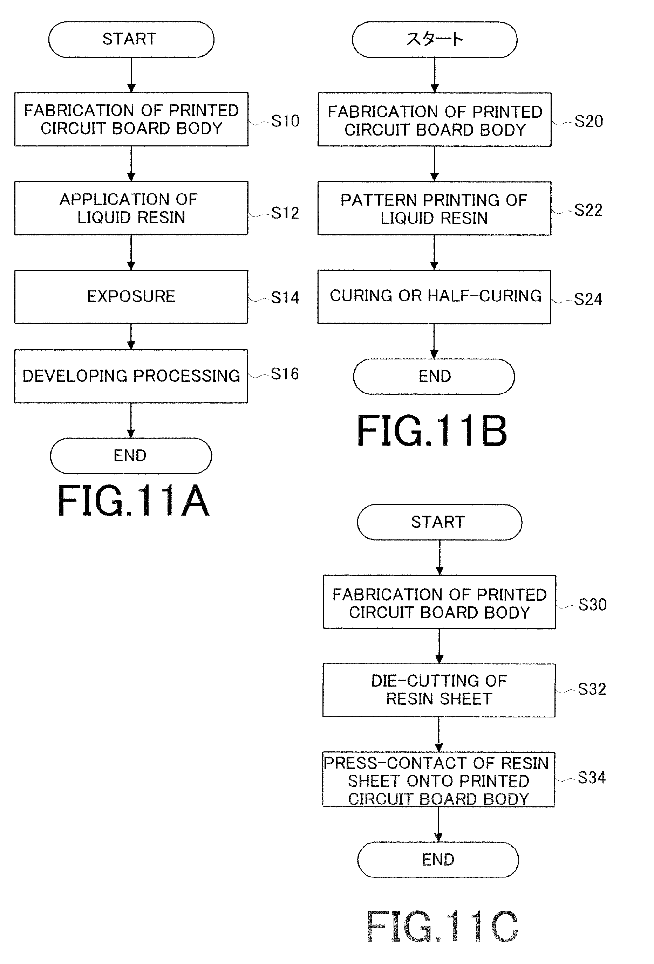

FIG. 11A is a flowchart explaining an exemplary method of fabricating the printed circuit board 13.

First, the printed circuit board body 12 is fabricated (Step S10). For example, a plurality of wiring layers is laminated and integrated in fabricating the printed circuit board body 12. The mounting pads 17 and the like are herein formed on the top surface of the printed circuit board body 12. The mounting pads 17 are connected to the lower wiring layer of the laminated wiring layers through the via-holes 34. Subsequently, the solder resist layer 28 is formed atop the printed circuit board body 12 without being formed on the mounting pads 17. Further, for instance, a surface processing including coating or plating and the like is executed for the mounting pads 17, the via-holes 34 and the like. The printed circuit board body 12 is fabricated through the above processing.

Next, a photosensitive thermoplastic resin is applied to the top surface of the printed circuit board body 12 on which the solder resist layer 28 is formed (Step S12), For example, the thermoplastic resin is a liquid resin containing a thermoplastic resin that is sensitive to ultraviolet light. More specifically, an acryl series resin, a polyester series resin, a vinyl chloride series resin or the like is herein used as the photosensitive thermoplastic resin. The liquid resin containing a thermoplastic resin may be a type of thermoplastic resin that a thermosetting resin is blended with a thermoplastic resin as the principal component.

Subsequently, an exposure device irradiates ultraviolet light to the applied liquid resin using a photo mask having a predetermined pattern (Step S14). When the liquid resin is a positive-type photosensitive resin, ultraviolet light is irradiated to the regions for through holes corresponding to the mounting pads 17. The exposed portions of the resin are neither cured nor photosensitized. In this case, the photo mask herein used has a pattern for irradiating the regions corresponding to the mounting pads 17.

Subsequently, a development processing is executed by soaking the exposed printed circuit board body 12 in a developer (Step S16). Then, a curing processing is executed. Through the above processing, the first reinforcement resin layer 30 is formed as a resin layer that contains a thermoplastic resin and includes a plurality of through holes formed to be aligned with positions of the mounting pads 17 for exposing the mounting pads 17 therethrough on a one-to-one basis.

The printed circuit board 13 is thus fabricated. It is herein noted that the first reinforcement resin layer 30 may be kept not in a cured state but in a half-cured state, more specifically, a B-staged state (a dry state in the case of a thermoplastic resin).

Instead of the flow illustrated in FIG. 11A, the printed circuit board 13 may be fabricated based on a flow illustrated in FIG. 11B.

First, the printed circuit board body 12 is fabricated by the method executed in the aforementioned Step S10 (Step S20).

Subsequently, a resin pattern is printed by a printing device using a printing plate onto the top surface of the printed circuit board body 12 on which the solder resist layer 28 is disposed (Step S22). In the pattern printing, a resin is printed on the regions intended to form the first reinforcement resin layer 30 therein without being printed on portions of the regions corresponding to the mounting pads 17.

Subsequently, the printed resin is cured or half-cured (F3-staged) either by heating the printed resin at a predetermined temperature for curing the printed resin or by irradiating the printed resin with ultraviolet light when the printed resin, is a photosensitive type (Step S24). When the printed resin is half-cured, an organic solvent contained in the resin is volatilized and dried. Thus, the first reinforcement resin layer 30 is formed in a cured state or a half-cured state (a B-staged state). When the first reinforcement resin layer 30 is at least in a half-cured state, a solder paste is allowed to be printed on the mounting pads 17 using a metal mask in mounting of the semiconductor packages 14a and 14b.

The printed circuit board 13 is thus fabricated.

Instead of the flow represented in FIG. 11A, the printed circuit board 13 may be fabricated based on a flow illustrated in FIG. 11C.

First, the printed circuit board body 12 is fabricated by the method executed in the aforementioned Step S10 (Step S30).

Subsequently, a thermoplastic resin sheet of a cured state is die-cut in the shape of the first reinforcement layer 30 (Step S32). In die-cutting the thermoplastic resin sheet, through holes are formed to be aligned with the positions of the mounting pads 17.

Next, the die-cut resin sheet is disposed in a predetermined position on the printed circuit board body 12 on which the solder resist layer 28 is disposed. Further, the die-cut resin sheet is heated and press-contacted to the printed circuit board body 12 (Step S34). The first reinforcement resin layer 30 is thus formed in a cured state.

In the printed circuit board 13 thus fabricated, a solder paste is applied onto each of the mounting pads 17 using the metal mask. Subsequently, each of the solder bumps 16 of the semiconductor packages 14a and 14b is disposed to make contact with the solder paste on each of the mounting pads 17. The semiconductor packages 14a and 14b are mounted on the printed circuit board 13 by means of soldering using a repair device.

Thus, the number of mounting steps can be reduced in mounting the semiconductor packages 14a and 14b on the printed circuit board 13 as illustrated in FIGS. 4 and 6 due to the fact that the first reinforcement resin layer 30 of at least a half-cured state is preliminarily formed on the printed circuit board 13. Further, it is possible to fabricate a printed circuit board unit with reinforced solder joints for allowing the semiconductor packages 14a and 14b to be repaired.

All examples and conditional language recited herein are intended for pedagogical purposes to aid the reader in understanding the invention and the concepts contributed by the inventor to furthering the art, and are to be construed as being without limitation to such specifically, recited examples and conditions, nor does the organization of such examples in the specification relate to a showing of the superiority and inferiority of the invention. Although the embodiment(s) of the present inventions have been described in detail, it should be understood that various changes, substitutions, and alternations could be made thereto without departing from the spirit and scope of the invention.

## Claims

1. A printed circuit board, comprising:
a printed circuit board body including a plurality of mounting pads; and
a resin layer containing a thermoplastic resin to be formed on a surface of the printed circuit board body,
wherein the resin layer includes a plurality of holes disposed to be aligned with positions of the mounting pads on a one-to-one basis for exposing the respective mounting pads therethrough.

2. The printed circuit board according to claim 1, wherein the resin layer is formed in a part of a prospective mounting region for an electronic component.

3. The printed circuit board according to claim 1 or 2,
wherein the printed circuit board body includes a solder resist layer formed to surround the respective mounting pads, and
the resin layer is disposed to be laminated on a part of the solder resist layer.

4. The printed circuit board according to any one of claims 1 to 3,
wherein a mounting height from the mounting pads to an electronic component to be mounted on the printed circuit board by means of soldering is preliminarily determined, and
a height from the mounting pads to a top surface of the resin layer is lower than the mounting height.

5. The printed circuit board according to claim 4, wherein the height from the mounting pads to the top surface of the resin layer is less than or equal to 150 µm.

6. The printed circuit board according to any one of claims 1 to 5, wherein the resin layer containing the thermoplastic resin is either in a B-staged state or in a cured state.

7. A printed circuit board, comprising;
a printed circuit board body including a plurality of mounting pads; and
a. resin layer of a B-staged state to be formed on a surface of the printed circuit board body,
wherein the resin layer includes a plurality of holes disposed to be aligned with the mounting pads on a one-to-one basis for exposing the respective mounting pads therethrough.

8. The printed circuit board according to claim 7, wherein the resin layer is formed in a part of a prospective mounting region for an electronic component.

9. The printed circuit board according to claim 7 or 8,
wherein the printed circuit board body includes a solder resist layer formed to surround the respective mounting pads, and
the resin layer is disposed to be laminated on a part of the solder resist layer.

10. A method of fabricating a printed circuit board, comprising:
fabricating a printed circuit board body including a plurality of mounting pads; and
forming either a resin layer containing a thermoplastic resin or a resin layer of a B-staged state on a surface of the printed circuit board body, the resin layer including a plurality of holes disposed to be aligned with positions of the mounting pads on a one-to-one basis for exposing the respective mounting pads therethrough.

11. The method of fabricating a printed circuit board according to claim 10, wherein the resin layer is formed on a part of a prospective mounting region for an electronic component.

12. The method of fabricating a printed circuit board according to claim 10 or 11,
wherein a solder resist layer is formed to surround the respective mounting pads on the printed circuit board body, and
the resin layer is disposed to be laminated on a part of the solder resist layer.

13. The method of fabricating a printed circuit board according to any one of claims 10 to 12,
wherein a mounting height from the mounting pads to an electronic component to be mounted on the printed circuit board by means of soldering is preliminarily determined, and
a height from the mounting pads from a top surface of the resin layer is lower than the mounting height.

14. The method of fabricating a printed circuit board according to claim 13, wherein the height from the mounting pads to the top surface of the resin layer is less than or equal to 150 µm.

15. The method of fabricating a printed circuit board according to any one of claims 10 to 14, wherein the resin layer containing the thermoplastic resin is either in a B-staged state or in a cured state.
